# EUROPÄISCHE PATENTSCHRIFT

(11) **EP 1 631 611 B1**
(45) Veröffentlichungstag und Bekanntmachung des Hinweises auf die Patenterteilung: **19.03.2008**
(21) Anmeldenummer: 04731164.2
(22) Anmeldetag: 05.05.2004
(51) Int. Cl.: C08G 61/12, H01B 1/12, H01L 51/30

(54) **HOCHREINE, IONENFREIE HALBLEITENDE POLYTHIOPENE, VERFAHREN ZU DEREN HERSTELLUNG UND DEREN VERWENDUNG ZUR HERSTELLUNG ELEKTRONISCHER BAUELEMENTE**
HIGHLY PURE, ION-FREE SEMICONDUCTING POLYTHIOPHENES, METHOD FOR THE PRODUCTION THEREOF, AND USE THEREOF FOR THE PRODUCTION OF ELECTRONIC COMPONENTS
POLYTHIOPHENES SEMI-CONDUCTEURS A HAUTE PURETE ET EXEMPTS D'IONS, PROCEDE DE PRODUCTION DESDITS POLYTHIOPHENES ET LEUR UTILISATION POUR LA FABRICATION DE COMPOSANTS ELECTRONIQUES

(30) Priorität: 30.05.2003 DE 10324554
(43) Veröffentlichungstag der Anmeldung: 08.03.2006
(73) Patentinhaber: Fraunhofer-Gesellschaft zur Förderung der angewandten Forschung e.V., 80686 München (DE)
(72) Erfinder: JANIETZ, Silvia, 14532 Stahnsdorf (DE); KRÜGER, Hartmut, 14469 Potsdam (DE); WEDEL, Armin, 14513 Teltow (DE)
(74) Vertreter: Ostermann, Dirk
(86) Internationale Anmeldenummer: PCT/EP2004/004769
(87) Internationale Veröffentlichungsnummer: WO 2004/106403

(56) Entgegenhaltungen:
- EP-A- 1 028 136
- US-A1- 2002 053 666
- MCCULLOUGH R D: "THE CHEMISTRY OF CONDUCTING POLYTHIOPHENES" 22. Januar 1998 (1998-01-22), ADVANCED MATERIALS, VCH VERLAGSGESELLSCHAFT, WEINHEIM, DE, PAGE(S) 93-116 , XP000727852 ISSN: 0935-9648 Seite 96, Spalte 2, Zeilen 46-48
- SHU HOTTA, MAMORU SOGA AND NOBUO SONODA: "Novel Organosynthetic routes to polythiophene and its derivatives" SYNTHETIC METALS, Bd. 26, 1988, Seiten 267-279, XP002289432

## Beschreibung

### Technisches Gebiet

Die vorliegende Erfindung betrifft hochreine, ionenfreie halbleitende Polythiophene, ein Verfahren zu deren Herstellung sowie deren Verwendung zur Herstellung elektronischer Bauelemente.

Insbesondere betrifft die Erfindung hochreine, ionenfreie Polythiophene, deren Herstellung und deren Verwendung als aktive Materialien mit reproduzierbaren Eigenschaften in elektronischen Bauelementen wie Feldeffekttransistoren, Diodenstrukturen, organischen Leuchtdioden oder photovoltaischen Zellen.

### Hintergrund der Erfindung

Für die Anwendung in elektronischen Bauelementen sind in der Regel definierte und hochreine Materialien, die insbesondere frei von ionischen Verunreinigungen sein müssen, notwendig. Insbesondere gilt das dann, wenn es nicht gelingt, reproduzierbare Gehalte dieser ionischen Verunreinigungen, die aus der Synthese der Materialien oder Reinigungsprozessen stammen können, einzustellen. Die elektronischen Eigenschaften der Bauelemente werden somit nicht nur von den Materialparametern sondern auch von den Verunreinigungen bestimmt.

### Stand der Technik

Polythiophene, insbesondere Poly(3-alkylthiophene), sind wegen ihrer im Vergleich zu anderen Polymeren erhöhten Ladungsmobilitäten als organische Materialien für die Herstellung elektronischer Bauelemente von Interesse.

Die bisher bekannten und kommerziell verfügbaren Poly(3-alkylthiophene) weisen deutliche Verunreinigungen durch Metall- und Halogenidionen auf, deren Gehalt sich von Charge zu Charge deutlich unterscheiden kann. Für die Anwendung in elektronischen Bauelementen ist dieses von entscheidendem Nachteil, weil die Verunreinigungen zu sehr unterschiedlichen Materialeigenschaften führen und zusätzlich die Lebensdauer der Bauelemente nachteilig beeinflussen können.

Für die Herstellung von Poly(3-alkylthiophenen) sind zwei unterschiedliche Syntheseverfahren bekannt.

Einerseits werden Poly(3-alkylthiophene) nach der so genannten Rieke-Methode hergestellt (R. D. Rieke, US Patent 5,756,653, 26.05.1998; siehe Schema 1). Dabei werden ausgehend von 2,5-dibromsubstituierten 3-Alkylthiophenen in-situ durch Umsetzung mit aktiviertem Zink Isomere des 2-Brom-3-alkyl-5-(bromzink)-thiophens bzw. 2-Bromzink-3-alkyl-5-bromthiophens erzeugt. (In Schema 1 ist nur ersteres als Zwischenstufe dargestellt.) Diese reagieren anschließend unter Zugabe eines Übergangsmetall-Katalysators, wie z.B. [1,2-bis(diphenylphosphino)ethan]-Nickel(II)chlorid (Ni(DPPE)Cl₂) oder auch Tetrakis-(triphenylphosphin)-palladium (0) (Pd(PPh₃)₄), zu den entsprechenden Polymeren.

Bei diesem bekannten Verfahren erfolgt die Aufreinigung der isolierten Polymere durch Ausfällen und Soxhlet-Extraktion mit verschiedenen Lösungsmitteln. Als wesentliche Verunreinigungen sind in den so erhaltenen Poly(3-alkylthiophenen) Zinkbromid (ZnBr₂), Nickelchlorid (NiCl₂) und Bromendgruppen enthalten. Diese lassen sich mit den klassischen Extraktionsverfahren nicht bis in den ppm-Bereich entfernen. Die Analysen von unterschiedlichen Chargen käuflich erworbener Poly(3-alkylthiophene) zeigen demgemäß sehr große Schwankungen hinsichtlich ihres Gehaltes an Zink und Brom.

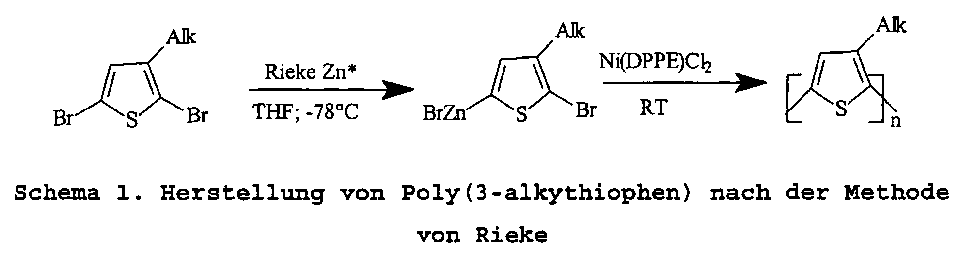

Ein zweites bekanntes Syntheseverfahren für Poly(3-alkylthiophene), das wesentlich einfacher in der Durchführung ist, nutzt die Grignard-Metathesereaktion, um Poly(3-alkylthiophene) aufzubauen (R. McCullough, R. Loewe, EP 1 028 136 A2, 16.08.2000; US 6,166,172, 26.12.2000; siehe Schema 2). Hier wird zunächst in-situ durch Umsetzung von 2,5-Dibrom-3-alkylthiophen mit Alkylmagnesiumbromid die entsprechende Thienylmagnesiumbromid-Verbindung hergestellt, die anschließend durch Zugabe eines Übergangsmetall-Katalysators, wie z.B. [1,3-Bis(diphenylphosphino)propan]-Nickel(II)chlorid (Ni(DPPP)Cl₂) polymerisiert wird.

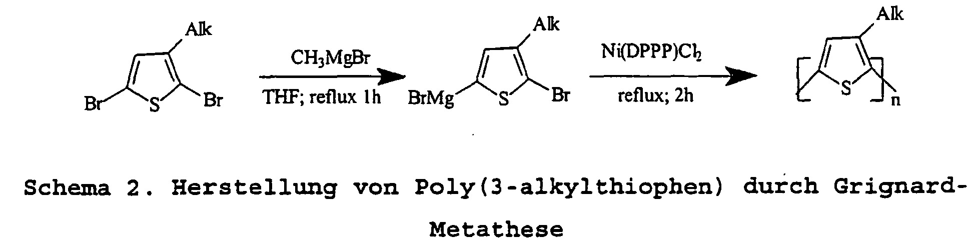

Auch bei diesem bekannten Verfahren erfolgt die Aufreinigung durch Extraktion der Rohprodukte mit Lösungsmitteln. In diesem Polymer sind bedingt durch die Synthese Magnesiumbromid, geringe Spuren Nickelchlorid und Bromendgruppen enthalten. Nachweislich gelingt auch hier die Entfernung der Reste mittels der klassischen Extraktionsverfahren nicht bis in den ppm-Bereich.

Mit beiden beschriebenen bekannten Verfahren gelingt es zwar, verarbeitbare Poly(3-alkylthiophene) herzustellen; diese weisen jedoch noch chargenabhängig differierende Gehalte von Metall- und Halogenidionen im Subprozent-Bereich auf, die zu nicht reproduzierbaren Eigenschaften daraus hergestellter elektronischer Bauelemente und zur Verschlechterung von deren Lebensdauer führen.

### Aufgabe der Erfindung

Der Erfindung liegt daher die Aufgabe zu Grunde, ein Verfahren bereitzustellen, das es gestattet, halbleitende Polythiophene insbesondere von ionischen Verunreinigungen zu befreien und damit den Aufbau von elektronischen Bauelementen daraus mit reproduzierbaren Eigenschaften zu ermöglichen.

### Zusammenfassung der Erfindung

Diese Aufgabe wird erfindungsgemäß gelöst durch ein Verfahren, umfassend die Stufen: (a) Behandeln von Polythiophen mit einer metallorganischen Verbindung in einem inerten Lösungsmittel und anschließendes Isolieren des so behandelten Polythiophens; (b) Auflösen des in der Stufe (a) erhaltenen Polythiophens in einem nicht wasserlöslichen organischen Lösungsmittel und inniges Kontaktieren der so erhaltenen Lösung (organische Phase) mit einer wässrigen Lösung eines Metallionenkomplexierungsmittels (wässrige Phase); (c) Trennen der wässrigen und der organischen Phase und Isolieren des hochreinen, ionenfreien Polythiophens aus der organischen Phase.

Durch die Erfindung wird somit erstmals ein hochreines, ionenfreies Polythiophen mit einem Gesamtgehalt an Brom vom weniger als 100 ppm und einem Gesamtgehalt an Zink, Nickel und Magnesium von weniger als 20 ppm bereitgestellt.

Des weiteren umfasst die Erfindung die Verwendung eines solchen hochreinen, ionenfreien Polythiophens zur Herstellung eines elektronischen Bauelements.

### Kurze Beschreibung der Zeichnungen

Fig. 1 zeigt die Strom-Spannungs-Kennlinien einer Dünnschichtdiode aus Poly(3-hexylthiophen) (siehe Anwendungsbeispiel 1; PHT = Poly(3-hexylthiophen)).
Fig. 2 zeigt die Strom-Spannungs-Kennlinien eines organischen Feldeffekttransistors (OFET) aus ungereinigtem Poly(3-hexylthiophen) bei unterschiedlichen Gate-Spannungen (siehe Anwendungsbeispiel 2).
Fig. 3 zeigt die Strom-Spannungs-Kennlinien eines organischen Feldeffekttransistors (OFET) aus erfindungsgemäß gereinigtem Poly(3-hexylthiophen) bei unterschiedlichen Gate-Spannungen (V_{g}) (siehe Anwendungsbeispiel 2).
Fig. 4 zeigt die Auftragung zur Bestimmung der Ladungsträgerbeweglichkeit aus dem OFET-Kennlinienfeld in Fig. 3 (siehe Anwendungsbeispiel 2, U_{g} = Gate-Spannung).

### Beschreibung bevorzugter Ausführungsformen der Erfindung

Die erste Stufe des erfindungsgemäßen Verfahrens, d.h. die Behandlung des Polythiophens mit einer metallorganischen Verbindung dient insbesondere der Entfernung von Bromendgruppen. Diese Stufe ist erforderlich, um den Bromgehalt der hergestellten Polythiophene hinreichend stark zu verringern. Dadurch wird insbesondere die Langzeitstabilität daraus hergestellter elektronischer Bauelemente deutlich erhöht. Polythiophene, die ohne Durchführung einer Behandlung mit einer metallorganischen Verbindung aufgereinigt worden waren, zeigten Brom-Gehalte im Sub-Mikro-Bereich (typischerweise 0,8 %).

Diese Stufe wird bevorzugt in der Weise durchgeführt, dass das Polythiophen in einem inerten Lösungsmittel gelöst wird, zu der so erhaltenen Lösung eine Lösung einer metallorganischen Verbindung zugegeben wird, das so erhaltene Gemisch, gegebenenfalls unter Erhitzen und/oder Rühren, der Reaktion überlassen wird und das behandelte Polythiophen anschließend ausgefällt wird.

Als inertes Lösungsmittel werden dabei bevorzugt aromatische Kohlenwasserstoffe wie z.B. Toluol verwendet. Um die Auflösung des Polythiophens in dem inerten Lösungsmittel zu beschleunigen, kann das Gemisch bis zur Siedetemperatur des inerten Lösungsmittels, bevorzugt auf eine Temperatur von bis zu etwa 60°C, erwärmt werden.

Die in der ersten Stufe des erfindungsgemäßen Verfahrens eingesetzte metallorganische Verbindung ist bevorzugt eine AlkylLithium-Verbindung wie zum Beispiel Butyllithium. Diese wird bevorzugt als Lösung in einem inerten organischen Lösungsmittel wie z.B. Hexan eingesetzt. Bevorzugt wird die Lösung der metallorganischen Verbindung in dem inerten organischen Lösungsmittel langsam zu der Lösung des Polythiophens unter einer Schutzgasatmosphäre zugetropft.

Bevorzugt wird die metallorganische Verbindung in einer solchen Menge eingesetzt, dass das Stoffmengenverhältnis von metallorganischer Verbindung zu Thiopheneinheiten in dem eingesetzten Polythiophen 0,1:1 bis 5:1, mehr bevorzugt etwa 1:1, beträgt.

Nach dem Vermischen des Polythiophens und der metallorganischen Verbindung wird das Reaktionsgemisch, gegebenenfalls unter Erhitzen und/oder Rühren, über einen Zeitraum von bevorzugt einer Minute bis zu 24 Stunden, mehr bevorzugt etwa einer Stunde, der Reaktion überlassen. Auch dabei wird das Reaktionsgemisch bevorzugt unter einer Schutzgasatmosphäre gehalten.

Die Isolierung des behandelten Polythiophens erfolgt bevorzugt durch Ausfällen durch Vermischen des Reaktionsgemischs mit einem Lösungsmittel, in dem das Polythiophen wenig löslich ist. Hierzu wird bevorzugt ein polares organisches Lösungsmittel wie z.B. Methanol eingesetzt. Vor dem Ausfällen des behandelten Polythiophens wird bevorzugt ein Teil des inerten Lösungsmittels und gegebenenfalls des inerten organischen Lösungsmittels, in dem die metallorganische Verbindung gelöst war, abdestilliert.

In der zweiten Stufe des erfindungsgemäßen Reinigungsverfahrens wird das in der ersten Stufe erhaltene Polythiophen zunächst in einem nicht wasserlöslichen organischen Lösungsmittel aufgelöst. Als nicht wasserlösliches organisches Lösungsmittel wird dabei bevorzugt Chloroform eingesetzt. Das Auflösen erfolgt bevorzugt unter Rühren und in einer Schutzgasatmosphäre.

Anschließend wird die so erhaltene Lösung (organische Phase) mit einer wässrigen Lösung eines Metallionenkomplexierungsmittels (wässrige Phase) innig kontaktiert. Als Metallionenkomplexierungsmittel werden bevorzugt Nitrido-triessigsäure (Komplexon^{(R)} I), Ethylendiamin-tetraessigsäure (Komplexon^{(R)} II) oder das Natriumsalz der Ethyldiamin-tetraessigsäure (Komplexon^{(R)} III) verwendet. Die Konzentration des Metallionenkomplexierungsmittels in der wässrigen Phase beträgt bevorzugt etwa 0,1 mol/l.

Das innige Kontaktieren erfolgt bevorzugt durch inniges, intensives Verrühren über einen Zeitraum von einer bis zu 24 Stunden. Das innige Kontaktieren der organischen und der wässrigen Phase erfolgt bevorzugt ebenfalls unter Schutzgasatmosphäre.

Durch Vergleichsversuche wurde festgestellt, das ein bloßes (auch mehrmaliges) "Ausschütteln", wie es üblicherweise im chemischen Labor durchgeführt wird, der organischen Phase mit der wässrigen Lösung eines Metallionenkomplexierungsmittels nicht ausreicht, um den Metallionengehalt der hergestellten Polythiophene hinreichend stark zu verringern. Vielmehr muss das Kontaktieren der organischen und der wässrigen Phasen über einen hinreichend langen Zeitraum bei hinreichend intensiver mechanischer Durchmischung erfolgen, wobei Dauer und Intensität des Kontaktierens anhand einfacher analytisch-chemischer Untersuchungen der erhaltenen Polythiophene festgelegt werden können.

Der pH-Wert der wässrigen Phase wird dabei bevorzugt neutral bis basisch, mehr bevorzugt im pH-Wert-Bereich von 9-12, gehalten. Bevorzugt wird dies durch Zugabe von wässriger Ammoniaklösung erreicht.

Nach dem innigen Kontaktieren werden die organische und die wässrige Phase getrennt. Bevorzugt wird die organische Phase einmal oder mehrmals mit Wasser gewaschen. Zur Isolierung des hochreinen, ionenfreien Polythiophens aus der organisches Phase wird diese bevorzugt über Kieselgel filtriert, gegebenenfalls eingeengt und das Polythiophen daraus durch Zugabe eines Lösungsmittels, in dem Polythiophen wenig löslich ist, wie z.B. Methanol, ausgefällt. Bevorzugt wird auch während dieser Schritte weiter unter Schutzgasatmosphäre gearbeitet. Nach Abtrennen des hochreinen, ionenfreien Polythiophens kann dieses zusätzlich noch einmal oder mehrmals umgefällt werden.

Die analytische Bestimmung von Brom und Metallionen in so erhaltenem Polythiophen zeigt, dass darin nur Spuren dieser Verunreinigungen im ppm-Bereich nachweisbar sind.

Das erfindungsgemäße Verfahren eignet sich insbesondere zur Herstellung von hochreinen, ionenfreien Polythiophenen, bei denen der Thiophenring in der 3-Stellung eine C₁-C₁₈-Alkyl-, C₁-C₁₈-Alkoxy- oder eine C₁-C₁₈-Alkylthioethergruppe trägt. Die Alkylgruppen können geradkettig oder verzweigt sein. Bevorzugte Alkylgruppen sind dabei Methyl, Ethyl, Propyl, Butyl, Pentyl, Hexyl, Heptyl und Octyl sowie iso-Propyl und 2-Ethylhexyl. Besonders bevorzugte Polythiophene sind (regioreguläre) Poly(3-(C₁-C₁₈)alkylthiophene). Besonders bevorzugt wird das Verfahren zur Herstellung von hochreinem, ionenfreiem Poly(3-hexylthiophen) angewendet.

Durch das erfindungsgemäße Verfahren wird erstmals hochreines, (fast) ionenfreies Polythiophen mit einem Gesamtgehalt an Brom von weniger als 100 ppm und einem Gesamtgehalt an Zink, Nickel und Magnesium von weniger als 20 ppm bereitgestellt. Dabei sind die genannten Gesamtgehalte als Massenanteile bezogen auf die Gesamtmasse des hochreinen, ionenfreien Polythiophens zu verstehen.

In besonders bevorzugten Formen des erfindungsgemäßen hochreinen, ionenfreien Polythiophens betragen die Gesamtgehalte an Brom weniger als 40 ppm bzw. an Zink, Nickel und Magnesium jeweils weniger als 5 ppm. Bevorzugt sind des Weiteren hochreine, ionenfreie Polythiophene mit einem Gesamtgehalt an Halogenen von weniger als 100 ppm bzw. einem Gesamtgehalt an Metallionen von weniger als 20 ppm. Besonders bevorzugt handelt es sich bei dem erfindungsgemäßen hochreinen, ionenfreien Polythiophen um Poly(3-hexylthiophen).

Die erfindungsgemäßen hochreinen, ionenfreien Poly(3-alkylthiophene) eigenen sich insbesondere zur Herstellung elektronischer Bauelemente wie z.B. Feldeffekttransistoren, Diodenstrukturen, organische Leuchtdioden oder photovoltaische Zellen.

### Beispiele

Nachfolgend wird die Erfindung anhand von Beispielen näher erläutert. Das Herstellungsbeispiel erläutert das erfindungsgemäße Verfahren. In den Anwendungsbeispielen werden die elektronischen Eigenschaften von Dünnschichtdioden und organischen Feldeffekttransistoren (OFET), die unter Verwendung von ungereinigtem, kommerziell verfügbarem bzw. unter Verwendung von nach dem erfindungsgemäßen Verfahren gereinigtem Poly(3-hexylthiophen) hergestellt wurden, verglichen.

### Herstellungsbeispiel

### 1. Analyse des Ausgangsmaterials

Kommerziell verfügbare, regioreguläre Poly(3-hexylthiophen)-Chargen wurden hinsichtlich ihrer Gehalte an Brom und Zink sowie hinsichtlich ihrer Molmassen untersucht.

Dabei wurde Brom nach einem Schöninger Aufschluss mittels Anionenchromatographie und Zink nach einem sauren Aufschluss mit 65%-iger Salpetersäure (HNO₃) in einem Mikrowellenofen durch anschließende induktiv gekoppelte Plasma-optische Emissionsspektrometrie (ICP-OES) bestimmt. Die selben Methoden wurden zur Analyse der erfindungsgemäßen Polythiophene angewendet.

Die Molmassen wurden mittels GPC (UV-Detektor) in THF mit Polystyrenstandard-Kalibrierung ermittelt. Die Ergebnisse sind in Tabelle 1 zusammengefasst.

**Tabelle 1**

| Ausgewählte Eigenschaften kommerziell verfügbarer, regioregulärer Poly(3-hexylthiophenene) | | | |
|---|---|---|---|
| **Charge** | **Bromgehalt** | **Zn-Gehalt** | **Molmassen** |
| 1 | 0,52% | 0,11% | M_{w}: 28700 g/mol |
| | | | Mₙ: 17300 g/mol |
| 2 | 1,19-1,25% | 0,61-0,59% | M_{w}: 42300 g/mol |
| | | | Mₙ: 16100 g/mol |
| 3 | 0,29% | 0,05% | M_{w}: 49700 g/mol |
| | | | Mₙ: 23600 g/mol |

### 2. Behandlung mit Butyllithium

25 g (z.B. 1,5 x 10⁻³ mol) des kommerziell verfügbaren Poly(3-hexylthiophens) wurden unter Argon und Rühren in zirka 2 1 Toluol eingebracht. Durch Erwärmen auf 60 °C ging das Polymer in Lösung. Dazu wurden dann langsam 100 ml (0,15 Mol BuLi) einer 1,6 molaren Butyllithiumlösung in Hexan zugetropft. Die Reaktionsmischung wurde ein Stunde unter Rückfluss gekocht und anschließend wurden zirka 300 ml Hexan/Toluol abdestilliert. Das Polymer wurde dann unter Argon in zirka 4 1 Methanol ausgefällt, abgesaugt und getrocknet.

Mittels Anionenchromatographie konnte Brom nur im ppm-Bereich nachgewiesen werden (0,004%, Ausschlussgrenze der Methode).

### 3. Behandlung mit Komplexon III

### 3.1 Behandlung mit Komplexon III durch Ausschütteln (Vergleichsversuch)

5 g des mit Butyllithium behandelten Poly(3-hexylthiophens), das wie vorstehend beschrieben erhalten wurde, wurden in 200 ml Chloroform unter Argon und Rühren gelöst und in einen Scheidetrichter überführt. Diese organische Phase wurde dreimal mit je 280 ml einer wässrigen Lösung, die 0,1 Mol des Dinatriumsalz der Äthylendiamintetraessigsäure (Komplexon III) enthielt, und 80 ml einer 25 %-igen Ammoniaklösung, die vorher auch mit Argon gespült wurden, ausgeschüttelt. Anschließend wurde die organische Phase mehrmals mit Wasser gewaschen, über eine Kieselgelsäule filtriert, eingeengt bis auf 25 ml und in einer mit Argon gespülten Methanol-Lösung ausgefällt und abgetrennt.

Die Untersuchung mittels induktiv gekoppelter Plasma-optischer Emissionspektrometrie ergab, dass immer noch Zink zu 0,37% enthalten waren (Ausgangsgehalt an Zink: 0,61%). Aus diesem Grund wurde eine andere Verfahrensweise entwickelt. Dieses Ergebnis zeigt, dass bloßes Ausschütteln nicht zu einer hinreichenden Verringerung des Metallionengehalts führt.

### 3.2. Behandlung mit Komplexon III durch inniges Kontaktieren

24 g des mit Butyllithium behandelten Poly(3-hexylthiophens), das wie vorstehend beschreiben erhalten wurde, wurden in 1 1 Chloroform unter Argon und Rühren in einem Sulfierkolben gelöst. Dazu wurden 1 1 einer wässrigen Lösung, die 0,1 Mol des Dinatriumsalz der Äthylendiamintetraessigsäure (Komplexon III) enthielt, und 400 ml einer 25 %-igen Ammoniaklösung, die vorher auch mit Argon gespült wurden, gegeben. Dieses Gemisch wurde 16 Stunden intensiv gerührt. Anschließend wurde die wässrige Phase abgetrennt. Die Chloroform-Phase wurde mehrmals mit Wasser gewaschen. Nach Filtration über eine Kieselgelsäule wurde die Chloroformlösung bis auf zirka 300 ml eingeengt und in mit Argon gespültem Methanol ausgefällt und abgetrennt. Nach Trocknen (4 h) unter Vakuum bei 40 °C wurden 20 g (83 % der Theorie) des Poly(3-hexylthiophens) isoliert.

Die Untersuchung mittels induktiv gekoppelter Plasma-optischer Emissionspektrometrie ergab, dass Zink zu 5 ppm nachgewiesen werden konnte (0,0005 %, Ausschlussgrenze der Methode).

### Anwendungsbeispiel 1

### Herstellung einer Dünnschichtdiode und deren Charakterisierung

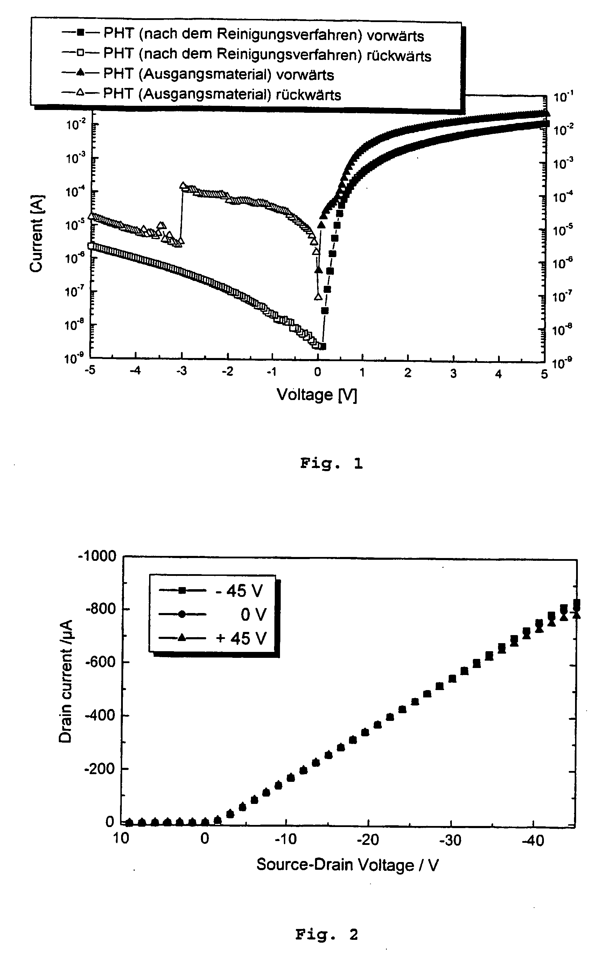

Eine Dünnschichtdiode wurde wie folgt aufgebaut: Auf einer Indium-Zinn-Elektrode (ITO) (effektive Fläche ca. 1 cm²) wurde das Poly(3-hexylthiophen) mit Hilfe eines spin-coating Verfahrens aufgebracht und bei 70 °C für 60 min getempert. Es wurde eine 1 %-ige Chloroform-Lösung des Poly(3-hexylthiophens) eingesetzt. Anschließend wurde eine Aluminiumelektrode unter Hochvakuumbedingungen (< 10⁻⁶ mbar) aufgedampft. Dieser Aufbau erfolgte sowohl mit ungereinigtem Poly(3-hexylthiophen) als auch mit gereinigtem Poly(3-hexylthiophen), das wie in dem Herstellungsbeispiel beschreiben erhalten wurde. Danach wurden die Strom-Spannungs-Kennlinien aufgenommen und miteinander verglichen; diese sind in Fig. 1 gezeigt.

Deutlich sichtbar sind die Unterschiede zwischen den Dünnschichtdioden aus den beiden Materialien. Zu erkennen sind insbesondere die verringerten Leckströme (Reduzierung der ionischen Verunreinigungen), ein besseres Gleichrichtungsverhältnis und ein ausgeprägteres Sperrverhalten bei der Dünnschichtdiode aus dem gereinigten Material.

Die ermittelten Gleichrichtungsverhältnisse für die wie vorstehend beschrieben hergestellten Dünnschichtdioden sind in Tabelle 2 zusammengefasst.

Aus diesen Daten ist ersichtlich, dass Dünnschichtdioden die unter Verwendung des erfindungsgemäßen hochreinen, ionenfreien Polythiophens hergestellt werden, z.B. als separate Gleichrichterdiode in elektronischen Schaltungen eingesetzt werden können.

**Tabelle 2**

| Gleichrichtungsverhältnisse von Dünnschichtdioden, die unter Verwendung von Poly(3-hexylthiophen) hergestellt wurden | | |
|---|---|---|
| verwendetes Poly(3-hexylthiophen) | **Gleichrichtungsverhältnis** | |
| | **bei 3 V** | **bei 5 V** |
| erfindungsgemäß gereinigt | 6.8 x 10⁵ | 1.5 x 10⁴ |
| ungereinigtes Ausgangsmaterial (kommerziell verfügbar) | 9_{.}8 x 10³ | 5.9 x 10² |

### Anwendungsbeispiel 2

### Herstellung von Feldeffekttransistoren und deren Charakterisierung

Es wurden organische Feldeffekttransistoren (OFETs) in Bottom-Gate-Struktur sowohl mit dem wie vorstehend beschrieben gereinigten als auch dem ungereinigten Poly(3-hexylthiophen) aufgebaut. Die Poly(3-hexylthiophen)-Lösung (1 % in Chloroform) wurde mit Hilfe einer Pipettiereinrichtung auf die Source-Drain-Strukturen getropft (ca. 0,5 ml). Danach wurde das Lösungsmittel durch einen Temperprozeß (65 °C für 60 min) entfernt. Die verwendeten OFET-Strukturen waren wie folgt gekennzeichnet: Source-Drain-Abstand: 20 µm, W/L-Verhältnis: 360, Gateschichtdicke (SiO₂) : 500 nm.

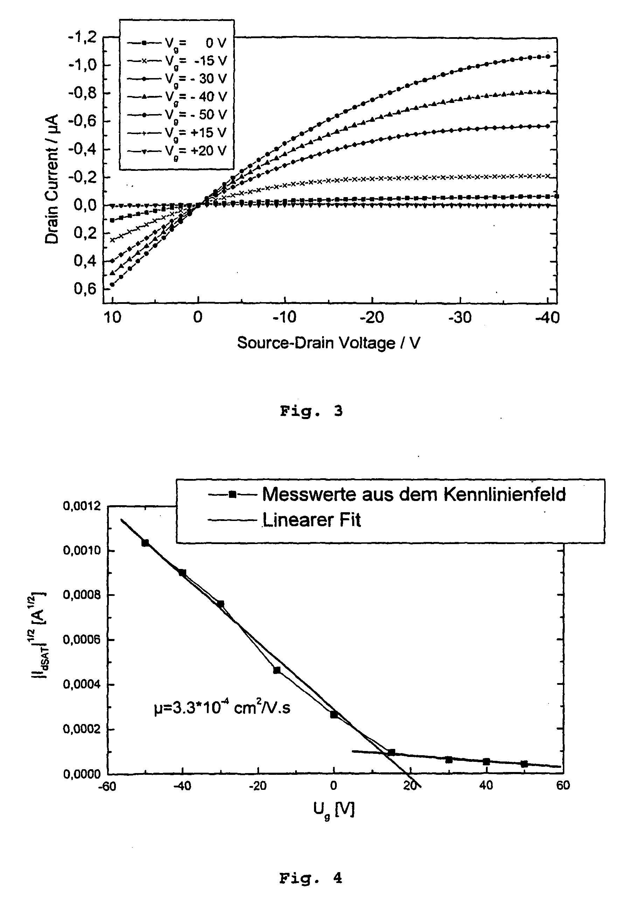

Die Kennlinien der so erhaltenen OFET-Strukturen sind in den Figuren 2 bzw. 3 gezeigt. OFET-Strukturen, die mit ungereinigtem Material hergestellt wurden, zeigen keinen Feldeffekt (Fig. 2). Es wird eine nahezu lineare Abhängigkeit des Drain-Stromes in Abhängigkeit von der Source-Drain-Spannung bei unterschiedlichen Gatespannungen beobachtet. Der Ladungstransport wird hierbei vorrangig von den ionischen Verunreinigungen verursacht. Aus diesem Grund sind die OFETs nicht für elektronische Schaltungen verwendbar und keine Ladungsträgerbeweglichkeiten bestimmbar.

OFET-Strukturen mit dem gereinigten Poly(3-hexylthiophen) zeigen einen deutlichen Feldeffekt (Fig. 3) und ein Sättigungsverhalten, aus denen dann die Ladungsträgerbeweglichkeiten bestimmt wurden.

Aus dem Kennlinienfeld des OFETs mit dem gereinigten Poly(3-hexylthiophen) wurde eine Ladungsträgermobilität von maximal 3.3 x 10⁻⁴ cm²/Vs ermittelt (siehe Fig. 4).

Diese Ergebnisse belegen ebenfalls, dass aus den erfindungsgemäßen Poly(3-alkyltiophenen) elektronische Bauelemente mit reproduzierbaren Eigenschaften aufgebaut werden können.

## Patentansprüche

1. Verfahren zur Herstellung von hochreinem, ionenfreiem Polythiophen, umfassend die Stufen:
(a) Behandeln von Polythiophen mit einer metallorganischen Verbindung in einem inerten Lösungsmittel und anschließendes Isolieren des so behandelten Polythiophens;
(b) Auflösen des in der Stufe (a) erhaltenen Polythiophens in einem nicht wasserlöslichen organischen Lösungsmittel und inniges Kontaktieren der so erhaltenen Lösung (organische Phase) mit einer wässrigen Lösung eines Metallionenkomplexierungsmittels (wässrige Phase);
(c) Trennen der wässrigen und der organischen Phase und Isolieren des hochreinen, ionenfreien Polythiophens aus der organischen Phase.

2. Verfahren nach Anspruch 1, wobei die Stufe (a) in der Weise durchgeführt wird, dass
- das Polythiophen in dem inerten Lösungsmittel gelöst wird,
- zu der so erhaltenen Lösung eine Lösung der metallorganischen Verbindung zugegeben wird,
- das so erhaltene Gemisch, ggf. unter Erhitzen und/oder Rühren, der Reaktion überlassen wird und
- das behandelte Polythiophen ausgefällt wird.

3. Verfahren nach einem der voranstehenden Ansprüche, wobei die metallorganische Verbindung eine Alkyllithiumverbindung ist.

4. Verfahren nach einem der voranstehenden Ansprüche, wobei die metallorganische Verbindung Butyllithium ist.

5. Verfahren nach einem der voranstehenden Ansprüche, wobei das Metallionenkomplexierungsmittel Nitridotriessigsäure, Äthylendiamintetraessigsäure oder das Dinatriumsalz der Äthylendiamintetraessigsäure ist.

6. Verfahren nach einem der voranstehenden Ansprüche, wobei das Isolieren des hochreinen, ionenfreien Polythiophens aus der organischen Phase in Stufe (c)
- das Filtrieren der organischen Phase über Kieselgel und/oder
- das Umfällen des Polythiophens
umfasst.

7. Verfahren nach einem der voranstehenden Ansprüche, wobei der Thiophenring des Polythiophens in der 3-Stellung eine C₁-C₁₈-Alkyl-, C₁-C₁₈-Alkoxy- oder eine C₁-C₁₈-Alkylthioethergruppe trägt.

8. Verfahren nach einem der voranstehenden Ansprüche, wobei das Polythiophen Poly(3-hexylthiophen) ist.

9. Hochreines, ionenfreies Polythiophen, wobei der Thiophenring des Polythiophens in der 3-Stellung eine C₁-C₁₈-Alkyl-, C₁-C₁₈-Alkoxy- oder eine C₁-C₁₈-Alkylthioethergruppe trägt, mit
- einem Gesamtgehalt an Brom von weniger als 100 ppm;
- einem Gesamtgehalt an Zink, Nickel und Magnesium von weniger als 20 ppm und
- einem Gesamtgehalt an Halogenen von weniger als 100 ppm.

10. Hochreines, ionenfreies Polythiophen nach Anspruch 9, wobei der Gesamtgehalt an Brom weniger als 40 ppm beträgt.

11. Hochreines, ionenfreies Polythiophen nach Anspruch 9, wobei der Gesamtgehalt an Zink, Nickel und Magnesium weniger als 5 ppm beträgt.

12. Hochreines, ionenfreies Polythiophen nach Anspruch 9, wobei der Gesamtgehalt an Metallionen weniger als 20 ppm beträgt.

13. Hochreines, ionenfreies Polythiophen nach einem der Ansprüche 9 bis 12, wobei das Polythiophen Poly(3-hexylthiophen) ist.

14. Verwendung eines hochreinen, ionenfreien Polythiophens nach einem der Ansprüche 9 bis 13 zur Herstellung eines elektronischen Bauelements.

15. Verwendung nach Anspruch 14, wobei das elektronische Bauelement ein Feldeffekttransistor, eine Diodenstruktur, eine organische Leuchtdiode oder eine photovoltaische Zelle ist.

## Claims

1. Method for the production of highly pure, ion-free polythiophene, comprising the steps:
a) treating polythiophene with an organometallic compound in an inert solvent and subsequent isolation of the thus-treated polythiophene;
b) dissolving the polythiophene obtained in step a) in an organic solvent which is not soluble in water and intimate contact of the thus-obtained solution (organic phase) with an aqueous solution of a metal ion complexing agent (aqueous phase);
c) separating the aqueous and the organic phase and isolating the highly pure, ion-free polythiophene from the organic phase.

2. Method according to claim 1, step a) being implemented in such a a manner that
- the polythiophene is dissolved in the inert solvent,
- a solution of the organometallic compound is added to the thus-obtained solution,
- the thus-obtained mixture is left to react, if necessary with heating and/or agitation, and
- the treated polythiophene is precipitated.

3. Method according to one of the preceding claims, the organometallic compound being an alkyl lithium compound.

4. Method according to one of the preceding claims, the organometallic compound being butyl lithium.

5. Method according to one of the preceding claims, the metal ion complexing agent being nitridotriacetic acid, ethylenediaminetetraacetic acid or the disodium salt of ethylenediaminetetraacetic acid.

6. Method according to one of the preceding claims, the isolation of the highly pure, ion-free polythiophene from the organic phase in step (c) comprising
- filtering the organic phase over silica gel and/or
- reprecipitation of the polythiophene.

7. Method according to one of the preceding claims, the thiophene ring of the polythiophene carrying a C₁-C₁₈ alkyl-, C₁-C₁₈ alkoxy- or a C₁-C₁₈ alkylthioether group in the 3-position.

8. Method according to one of the preceding claims, the polythiophene being poly(3-hexylthiophene).

9. Highly pure, ion-free polythiophene, the thiophene ring of the polythiophene carrying a C₁-C₁₈ alkyl-, C₁-C₁₈ alkoxy- or a C₁-C₁₈ alkylthioether group in the 3-position, with
- a total content of bromine of less than 100 ppm;
- a total content of zinc, nickel and magnesium of less than 20 ppm and
- a total content of halogens of less than 100 ppm.

10. Highly pure ion-free polythiophene according to claim 9, the total content of bromine being less than 40 ppm.

11. Highly pure, ion-free polythiophene according to claim 9, the total content of zinc, nickel and magnesium being less than 5 ppm.

12. Highly pure, ion-free polythiophene according to claim 9, the total content of metal ions being less than 20 ppm.

13. Highly pure, ion-free polythiophene according to one of the claims 9 to 12, the polythiophene being poly(3-hexylthiophene).

14. Use of a highly pure, ion-free polythiophene according to one of the claims 9 to 13 for the production of an electronic component.

15. Use according to claim 14, the electronic component being a field effect transistor, a diode structure, an organic light diode or a photovoltaic cell.

## Revendications

1. Procédé de production de polythiophènes de haute pureté,exempts d'ions, comprenant les étapes suivantes :
(a) traitement de polythiophène avec un composé organo-métallique dans un solvant inerte et ensuite isolement du polythiophène ainsi traité ;
(b) dissolution du polythiophène obtenu dans l'étape (a) dans un solvant organique non hydrosoluble et mise en contact intime de la solution ainsi obtenue (phase organique) avec une solution aqueuse d'un agent complexant les ions métalliques (phase aqueuse) ;
(c) séparation de la phases aqueuse et de la phase organique et isolement du polythiophène exempt d'ions, de haute pureté, à partir de la phase organique.

2. Procédé selon la revendication 1, selon lequel l'étape (a) est effectuée de la manière suivante :
- on dissout le polythiophène dans un solvant inerte,
- on ajoute à la solution ainsi obtenue une solution d'un composé organométallique,
- on laisse réagir le mélange ainsi obtenu, le cas échéant avec chauffage et/ ou agitation, et
- on précipite le polythiophène traité.

3. Procédé selon l'une des revendications précédentes, selon lequel le composé organométallique est un composé alkyllithium.

4. Procédé selon l'une des revendications précédentes, selon lequel le composé organométallique est le butyllithium.

5. Procédé selon l'une des revendications précédentes, selon lequel l'agent complexant les ions métalliques est l'acide nitrurotriacétique, l'acide éthylènediaminetétraacétique ou le sel de disodium de l'acide éthylènediaminetétraacétique.

6. Procédé selon l'une des revendications précédentes, selon lequel l'isolement du polythiophène exempt d'ions, de haute pureté, à partir de la phase organique de l'étape (c) comprend
- la filtration de la phase organique sur du gel de silice et/ ou
- la précipitation du polythiophène.

7. Procédé selon l'une des revendications précédentes selon lequel le noyau thiophène du polythiophène porte en position 3 un groupe alkyle en C₁ - C₁₈, alcoxy en C₁ - C₁₈ ou alkyle en C₁ - C₁₈ thioéther.

8. Procédé selon l'une des revendications précédentes, selon lequel le polythiophène est le poly(3-hexylthiophène).

9. Polythiophène de haute pureté exempt d'ions, dans lequel le noyau thiophène porte, en position 3, un groupe alkyle en C₁ - C₁₈, alcoxy en C₁- C₁₈, ou alkyle en C₁ - C₁₈ thioéther, présentant :
- une teneur totale en brome inférieure à 100 ppm ;
- une teneur totale en zinc, nickel et magnésium inférieure à 20 ppm ; et
- une teneur totale en halogènes inférieure à 100 ppm.

10. Polythiophène exempt de haute pureté, exempt d'ions métalliques, selon la revendication 9, dans lequel la teneur totale en brome est inférieure à 40 ppm.

11. Polythiophène exempt de haute pureté, exempt d'ions métalliques, selon la revendication 9, dans lequel la teneur totale en zinc, nickel et magnésium est inférieure à 5 ppm.

12. Polythiophène exempt de haute pureté, exempt d'ions métalliques, selon la revendication 9, dans lequel la teneur totale en ions métalliques est inférieure à 20 ppm.

13. Polythiophène exempt de haute pureté, exempt d'ions métalliques, selon une des revendications 9 à 12, ce polythiophène étant le poly (3-hexylthiophène).

14. Utilisation d'un polythiophène de haute pureté, exempt d'ions métalliques, selon l'une des revendications 9 à 13 pour la fabrication d'un composant électronique.

15. Utilisation selon la revendication 14, le composant électronique étant un transistor à effet de champ, une structure de diode, une diode électroluminescente organique ou une cellule photovoltaïque.
